# EUROPEAN PATENT APPLICATION

(11) **EP 4 311 067 A1**
(43) Date of publication of application: **24.01.2024**
(21) Application number: 22186054.7
(22) Date of filing: 20.07.2022
(51) Int. Cl.: H02J 7/00, G01R 31/36, G01R 31/392, H02J 9/06, H05B 47/00

(54) **METHOD AND SYSTEM FOR FACILITATING ADAPATED MAINTENANCE OF EMERGENCY LIGHTING SYSTEMS**

(30) Priority: 18.07.2022 EP 22185380
(71) Applicant: Tridonic GmbH & Co KG, 6851 Dornbirn (AT)
(72) Inventor: Wilson, Ian, 6850 Dornbirn (AT)
(74) Representative: Beder, Jens

(57) **Abstract**

System and method for facilitating maintenance of an emergency lighting system (1) in which an operating device (5) is configured to at least temporarily operate a light source (4) from electrical energy stored in a rechargeable battery (3). System measurement values and/or events are repetitively determined during operation of the operating device (5) and stored in an internal memory (9) of the operating device (5). The oldest corresponding stored data is cyclically overwritten. At least part of the stored data is transferred to an external memory (12) at a plurality of different times thereby accumulating measurement values and/or information on events in the external memory (12). A processing means (13) analyses at least part of the accumulated measurement values and/or information on events to determine a state of at least one component of the emergency lighting system (1), and generates an indicator for the determined state, such as the state of health of the battery. The determined state of the at least one component is signalled based on the indicator.

## Description

The invention relates to a method and a system for facilitating adaptive maintenance of emergency lighting systems.

Emergency lighting systems are highly safety relevant. Thus, uninterrupted operation thereof or at least the readiness to immediately be operated in case of an emergency is necessary. Consequently, emergency lighting systems are required to undergo regular maintenance and function tests. One important aspect is the battery, which needs to be capable of storing enough energy to enable operation of a light source of the emergency lighting system for a defined time period. This time period is called rated duration and may be different in different countries. Examples for typical rated durations are one hour or three hours. The emergency lighting systems are regularly tested whether the rated duration can be achieved. Sometimes, these systems comprise a so-called "black box" which is an internal monitoring unit of the operating device of the emergency lighting system that is capable of storing values measured during the rated duration test or regular operation of the emergency luminaire. It is to be noted that in the context of the present invention and the background of the related art, the expression "regular operation" refers to any kind of operation except for dedicated test routines. Thus, "regular operation" also includes situations when there are for example high/low temperature were when there are excessive mains interruption cycles.

However, such a rated duration test is only meaningful with respect to the current situation of the emergency luminaire. As long as the rated duration test is passed, the entire emergency luminaire is considered to properly function. Unfortunately, this does not mean that any component of the emergency luminaire is in a state that may be assumed to ensure that for the time period until the next rated duration test is performed, the function will still be given. In order to avoid an unexpected failure of the emergency luminaire, regular maintenance of the emergency luminaire is therefore required. This is particularly important for the battery, which is one of the crucial components of an emergency luminaire. It is well-known that battery capacity decreases over time. The decrease of the battery capacity depends on a number of different influences such as environmental influences like for example temperature, but also influences caused by the operation of the emergency luminaire. For example charging cycles also have an effect on the ageing (degradation) or the remaining life expectancy of the rechargeable battery of an emergency luminaire. Since an emergency luminaire is a safety relevant component of a (emergency) lighting system, it must be avoided that degradation of a battery capacity causes failure in case of emergency. Currently, this is achieved by precautionary change of the battery of an emergency luminaire at regular, predefined time intervals. Unfortunately, this leads to replacement of batteries that are still in good condition and might even be used for a longer time. On the other hand, it cannot be excluded that due to unpredictable circumstances battery ageing is faster than expected and a particular battery may even not reach the point in time where it should be replaced as a precautionary measure. So this could lead to a situation in which the emergency luminaire may not be able to provide illumination in an emergency case for the rated duration.

It is to be noted that the explanations given above are presented specifically with respect to the rechargeable battery of an emergency luminaire. As the skilled person may easily understand, the same considerations are true for other components of the emergency luminaire or an entire emergency luminaire system in a similar manner. Thus, it would generally be desirable to enable an adapted maintenance in order to avoid surprising system failure.

Such improved maintenance is achieved by the method and system according to the attached independent claims. The dependent claims define advantageous embodiments and aspects of the present invention.

According to the present invention, the emergency lighting system for facilitating maintenance of an emergency lighting system comprises a rechargeable battery, an operating device configured to at least temporarily operate a light source, typically an LED or a plurality of LEDs, from energy stored in the rechargeable battery, the operating device comprising an internal memory. The battery, the operating device and the light source form an emergency luminaire. Of course, the emergency luminaire may comprise additional components, which are not mentioned here since they do not directly concern the present invention. Additionally, the emergency lighting system according to the present invention comprises an external memory and processing means.

The operating device of the emergency luminaire is configured to repetitively determine system measurement values and/or events during operation of the operating device. Measurement values may be obtained directly by using sensors physically sensing the respective parameters of the emergency luminaire. Events that may be determined could be detected from the measured values, for example by processing the measured values by the processing means of the operating device. For example, from a measured supply voltage, the peak value can be determined, the peak been identified as "event".

The operating device stores the determined measurement values and/or information on the determined events in the internal memory of the operating device. This procedure may easily be realized in operating devices equipped with so-called black boxes (monitoring units) having a limited memory capacity and also processing capabilities. Due to the limited memory capacity in the operating device, data stored in the internal memory is cyclically overwritten. This means, that new measurement values or updated information on determined events will overwrite the respective measurement values or informational events (hereinafter generally referred to as data) already stored in the internal memory. "Information on determined events" could for example be a count number indicating how often a certain event (excessive temperature, mains failure, reaching a cut-off level,...) occurred. Other information on events may overwrite the previously stored information, which characterized the event itself, for example a maximum or minimum temperature, or an average temperature, in case the values change over time. According to the invention, the system comprises an external memory in addition to the internal memory of the operating device. Such an external memory is arranged outside of the emergency luminaire but connected to the operating device such that a data transfer from the internal memory to the external memory is possible. "Data" in this context means the measurement values and information on events as it is stored in the internal memory of the emergency luminaire. The external memory may be arranged in a cloud or, for example, in a server connected to the emergency luminaire or even a plurality of additional emergency luminaires. Thus, the external memory may receive data from a plurality of internal memories each associated with a different emergency luminaire.

The memory capacity of the external memory is significantly larger than the very limited internal memory capacity, which is available inside the operating device. Consequently, it is not necessary to overwrite data, which is already stored in the external memory. Thus, the measurement values and/or information on events, which are obtained or determined by the operating device and stored in the internal memory, are accumulated in the external memory. By accumulating the data in the external memory, the basis for an analysis of the state of at least one component of the emergency luminaire is significantly improved. Thus, according to the invention, the processing means also external to the operating device and coupled to the external memory is configured to perform an analysis based on the accumulated measurement values and/or information on events. This analysis performed based on the accumulated data (measurement values and/or information on events) allows to determine a state of at least one component of the emergency lighting system, particularly a certain emergency luminaire or component thereof like, for example, its rechargeable battery.

The "state" of a component can be a qualitative estimation whether the respective component is in good condition or in a bad condition. Thus, the state may define a category into which the respective component is categorised based on the analysis of one or more measurement values and/or information on events. In the simplest case, the analysis comprises a comparison of a particular measurement value or information on an event (for example, a count of experienced events of the same type) with a given threshold.

In such a simple case, only two categories are used to indicate the state of the component. Obviously, it is also possible to use a plurality of categories or even an unlimited number leading to the continuous description of the state.

Once the state of a component is determined, an indicator for the determined state is generated. This could be a signal containing information on the determined state or a value unambiguously identifying the determined state. For example, a value between 0% and 100% may be used in order to indicate the determined state of health of a battery. 100% would reflect that the battery is new and no degradation at all has occurred yet. On the other hand, 0% would indicate that the remaining life expectancy is zero and replacement of the components necessary. Based on the indicator the determined state of the at least one component is signalled. Signalling may either be used in order to transmit the information on the determined state to another entity where it is finally output or it may be used for further processing of the information. Further, signalling maybe understood as presenting the respective determined state to an operator. This can be achieved using a dashboard displaying the determined state of health of the component. The output of the state using the dashboard informs an operator of the system of the determined state of the component. The operator is then able to decide whether replacement of the battery (or another component) is urgent or may be deferred.

It is evident, that a plurality of states may be determined relating to the plurality of different components. The signalling of the determined state(s) may either concern only one state or a plurality of states at the same time. This may be achieved if the signalling is performed using a displayed dashboard in which a plurality of information items can be displayed simultaneously. Thus, such a dashboard allows the operator of the system to easily recognise the overall "state of health" of the emergency luminaire. Using a dashboard for signalling a plurality of states for a plurality of components has the great advantage, that the operator of the system can easily get an overview over the entire system and not only a single component. On the other hand, the dashboard can be used to not only display the state of a component or a plurality of components but also the measurement values and/or information on events directly. This allows an improved analysis by the operator.

As mentioned above, the rechargeable battery of an emergency luminaire, which is part of an emergency lighting system, maybe considered to be the most problematic component because of decrease of its capacity. Thus, according to an advantageous aspect of present invention, the battery capacity of the rechargeable battery is determined as one measurement value based on a duration test discharging the battery to a state of charge threshold. It is to be noted, that this duration test significantly differs from the known so-called rated duration tests which are compulsory for emergency luminaires and which only test the function for the rated duration. However, in case that the rated duration test is passed, no additional information is obtained regarding the actual age of the battery or the current state of degradation describing the current state of the battery. Thus, contrary to the compulsory rated duration tests, according to the present invention, the duration test discharges the battery to a fixed stage of charge threshold and not only for a certain period of time. This threshold is also known to be a so-called cut off voltage. The cut off voltage is only reached in case that the rechargeable battery is almost completely discharged and operation of the emergency luminaire can no longer be performed. Thus, from such a duration test, the actual capacity of the rechargeable battery may easily be determined by measuring the time which is necessary to discharge the battery to the cut-off level. In the end, the remaining capacity of the battery, which decreases which the age of the battery, is most important for guaranteeing the function of the emergency luminaire. The state of health, or just state of the battery may define the determined remaining capacity of the battery.

According to another advantageous aspect, it is preferred to determine the relative capacity of the rechargeable battery. Relative capacity means that the percentage of the initial capacity of the rechargeable battery is determined and the ratio of the actual capacity of the rechargeable battery and the initial capacity is calculated. Even batteries of the same type having the same nominal value for the capacity, have a variation in their actual capacity even in case that they are brand-new. The relative capacity is used in order to estimate the state of the rechargeable battery. This is performed using an initial measurement characterizing the initial capacity of a battery of an emergency luminaire and storing the respective initial value in the external storage so that it is available for calculation of the relative capacity. This might be performed by running a duration test in which the battery is discharged to the threshold for the state of charge as indicated above, wherein this first duration test is performed directly when the emergency luminaire is commissioned. In case that the batteries replaced, this initial duration test will be conducted for the replaced battery immediately after replacement. One possible way to calculate the relative capacity is to calculate the ratio of the time to run from fully charge to fully discharged (threshold reached) at each point of measurement.

According to a further advantageous aspect, the relative capacity is used in order to determine the state of the rechargeable battery. This is achieved by comparing the relative capacity with a capacity threshold which is a function of battery age. This allows to determine whether the rechargeable battery undergoes an overly rapid degradation or ageing from which it could concluded that the required life expectancy cannot be reached by this particular rechargeable battery. From the determination of the relative capacity, and in particular if the course of the relative capacity over time is taken into consideration, the remaining life expectancy can be estimated. Thus, based on such estimated life expectancy an approximate prediction for a precautionary replacement of the battery can be determined and output on the dashboard to the operator.

It is particularly advantageous to use a model, which calculates based on the measurement values and/or information on events, the state of health and/or the remaining life expectancy, thereby allowing to calculate a point in time when the precautionary replacement should be performed. Although such a model could be generated for any of the components of the emergency luminaire, it is particularly preferred to create a model for the battery of the emergency luminaire.

It is to be noted that it is particularly preferred to perform the analysis based on data, which is stored in the external memory, in addition to an internal analysis of the measurement values and/or information on the determined events performed in the operation device of each emergency luminaire. Such an internal analysis may be performed by a monitoring unit of the operating device, commonly denoted as "blackbox" as mentioned above. Such black boxes are already known and used in order to recognise system failures in response to which an alert might be output. Thus, such an internal monitoring of the system by measuring certain parameters of the operating device and producing warning signals can be maintained as already known. However, the additional capability of analysing a larger amount of data enables an improved analysis of data, which is available from the blackbox of the emergency luminaire and its internal memory,

In order to enable an improved accuracy of the analysis which is performed based on data stored in the external storage, it is desirable to improve the database for such an analysis. In case that only the very limited capacity of the memory of the black box is used, the accuracy of the analysis result may also be limited. Thus, according to an advantageous aspect, the system comprises, in addition to the internal memory of the operating device, a supplementary memory, also arranged in the operating device. Using such a supplementary memory allows at least temporarily storing an additional amount of data, for example, measured values or information on determined events. The measurement values that are stored in the supplementary memory may then either be transferred to the external memory at (regular) time intervals, for example once or twice a day, or the amount of data stored in the supplementary memory is reduced in the operating device before the transfer to the external memory is executed. The reduction of the amount of data may for example be achieved by preprocessing the stored measurement values. Preferred preprocessing includes at least one of: calculating an average value, determining a peak value and determining a minimum value. The result of preprocessing of the data stored in the supplementary memory may then be stored in the internal memory so that it is transferred to the external memory together with the other measurement values and/or information on events stored in the internal memory anyway.

In case that such a supplementary memory is available, it is particularly preferred that the time interval between successive determinations of measurement values that are stored in the supplementary memory is shorter than the time intervals between successive determinations of measurements stored in the internal storage. Thus, while the internal memory is too small to store enough information with respect to a particular characteristic such that the development of the characteristic can be analysed, such analysis becomes possible based on the data stored in the supplementary memory. Since the read out of the data stored in the internal memory and in the supplementary memory (if provided) is preferably performed on the regular basis, for example once a day or twice a day, a large amount of data representing the history of events and influences experienced by the emergency luminaire can be accumulated in the external memory.

It is to be noted that one great advantage of the inventive system and inventive method of facilitating adaptive maintenance of an emergency system is that the additional functionality provided by the present invention can be added to an existing emergency luminaire. In case that the existing emergency luminaire already comprises the blackbox which stores at least a basic set of measurement values and information on events, the present invention allows to conduct an improved analysis by transferring the data to an external memory and perform the calculations needed for an analysis based on the accumulated data stored in the external storage. So the present system has the great advantage that an adaptation of the emergency luminaire and in particular the operating device of the emergency luminaire is not necessary. The only prerequisite for such an approach is that the operating device of existing emergency luminaire, allows to obtain the stored data from its internal memory. This is for example possible for operating devices that are connected to a so-called DALI (digital addressable lighting interface) bus system which enables requesting for transfer of data from a connected external device.

The invention will now be explained with reference to the attached drawings illustrating preferred embodiments of the invention. The embodiments will show further aspects of the invention. In the drawings
- Fig. 1: is a block diagram illustrating the main components according to the emergency lighting system of the present invention,
- Fig. 2: is a simplified flowchart of the method according to the present invention,
- Fig. 3: illustrates the degradation of the battery capacity over time,
- Fig. 4: illustrates the difference between a rated duration test and the duration test according to the present invention,
- Fig. 5: is an illustration explaining the degradation of a rechargeable battery over time,
- Fig. 6: shows an example for determining additional measurement values and storing them in a supplementary memory,
- Fig. 7: shows an example for a change over time of the charging micro cycles,

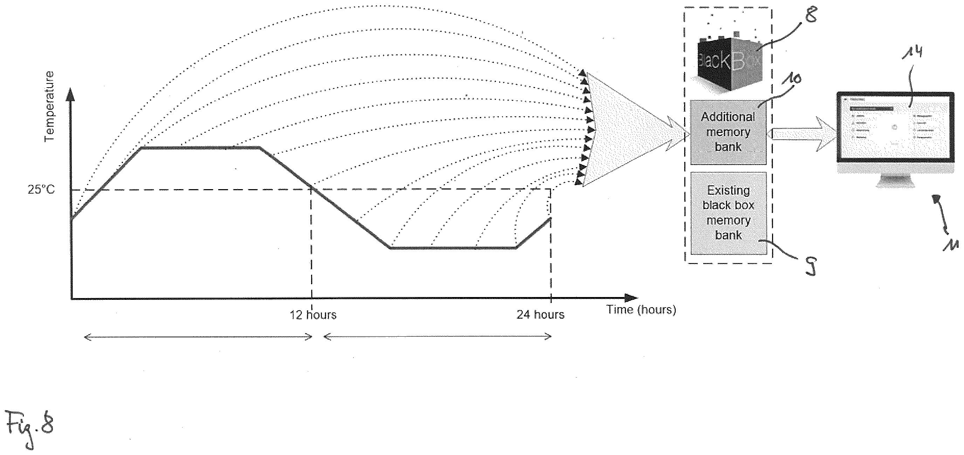

- Fig. 8: shows a further example for determining additional measurement values and storing them in the supplementary memory, and
- Fig. 9: shows an example for a dashboard used for signalling the determined state and additional information to an operator of the emergency lighting system.

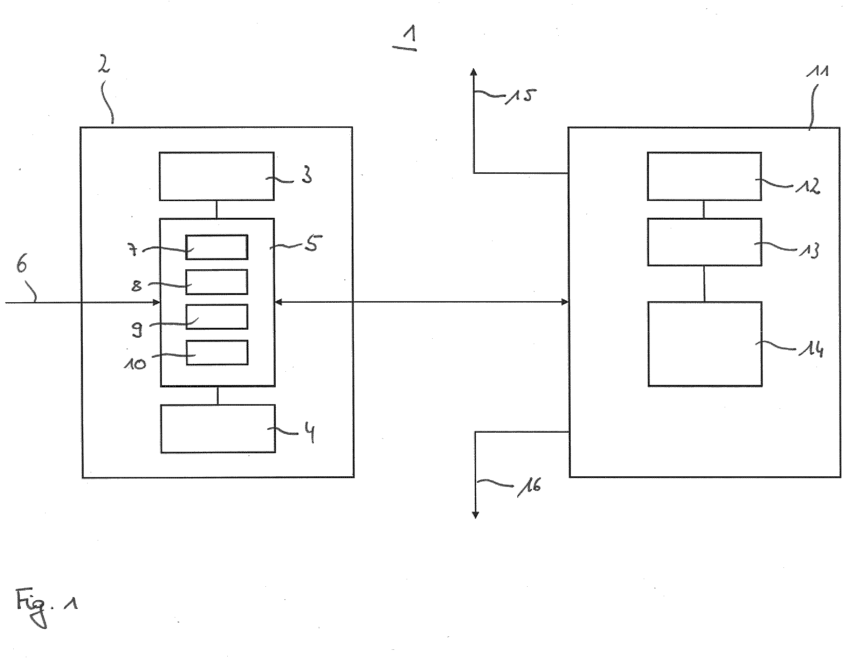

Figure 1 shows a schematic of an emergency lighting system 1 according to the present invention. The emergency lighting system 1 comprises an emergency luminaire 2. In the emergency luminaire 2, a rechargeable battery 3 is arranged storing electrical energy. The electrical energy stored in the rechargeable battery 3 is used in order to drive a light source, which in modern emergency luminaires is realised by a plurality of LEDs 4. The LEDs 4 are driven or operated by an operating device 5.

The operating device 5 is further configured to charge the rechargeable battery 3 as long as a mains power supply 6 is available. In case of an emergency and when the mains power supply 6 fails, the operating device 5 automatically switches the power supply to the battery 3 and provides an operating voltage and current to the LEDs 4 based on electrical energy which is taken from the battery 3. It is to be noted that in an alternative configuration, it is also possible to provide a dedicated charger in order to charge the battery 3 from the mains power supply.

The function of the emergency luminaire therefore depends on the correct function of the battery 3. This means that a minimum capacity of the battery 3 must be ensured in order to achieve a duration of illumination by the LED 4 that satisfies the requirements (greater duration).

It is to be noted that the configuration of the emergency luminaire 2 described above is a well known emergency luminaire 2 and a detailed description of its components and functions is omitted for the sake of conciseness.

The operating device 5 comprises a converter 7 producing an output signal for driving the LEDs 4. Further, processing means 8, for example a microcontroller or the like is arranged in the operating device 5. This processing means 8 together with an internal memory 9 is also known from state-of-the-art solutions. The processing means 8 and the internal memory 9 commonly establish a black box that is used to monitor quite a number of different parameters of the emergency luminaire 2 or attached components and that stores the results of such monitoring in the internal memory.

According to the present invention, since the capability of analysing information determined in the emergency luminaire 2 shall be improved, a supplementary memory 10 is arranged in the operating device 5. As it will become clearer hereinafter when the determination of the state of the rechargeable battery 3 is explained in more detail, the supplementary memory 10 allows to enhance the database for the analysis which is performed outside the operating device 5.

The emergency luminaire 2 is connected to a control device 11. The control device 11 can be a dedicated computer or a cloud service allowing to store data and process the data in order to analyse a state of at least one of the components of the emergency luminaire 2. For the sake of conciseness, only the dedicated computer as an example for the control device 11 will be used for the explanations given hereinafter. Of course, the skilled person is readily able to realise all the functionality described with respect to the control device 11 also by a cloud service.

The control device 11 comprises an external storage 12, a processing means 13 like a microprocessor, and a display 14. In the external storage 12, data that is originally determined in the emergency luminaire 2 is accumulated. Based on the accumulated data, the processing means 13 performs an analysis in order to determine a state of at least one component of the emergency luminaire 2. For facilitating the understanding of the present invention, the following explanations will only refer to the state of health or state of the rechargeable battery 3 of the emergency luminaire 2.

The result of the analysis 13, describing the state of the rechargeable battery 3 is an indicator generated based on at least some of the data accumulated in the external memory 12. The indicator is an identifier of the category into which the battery 3 has been categorised based on an analysis of at least some of the data that is available in the external memory 12. The categories could for example be "faulty" and "in good condition" in case that the state is categorised on a binary basis.

Based on the indicator, the corresponding determined state of the component, here the rechargeable battery 3, is signalled. Mostly, signalling means that the respective information is visually presented to an operator using the display 14. However, signalling could also mean that a signal is generated that is used to transfer information on the determined state of the component to another entity, which is capable of further processing the signal. For example, automated routines could be triggered by such other entity. Such an automated routine could for example be switching on a warning light or outputting an alarm tone based on the content of the signal, or automatically sending an email to a service engineer.

For the sake of conciseness and simplicity of the drawing, the emergency lighting system 1 was illustrated using only a single emergency luminaire 2. However, as indicated by the additional arrows 15 and 16, a plurality of emergency luminaires might be connected to the control device 11.

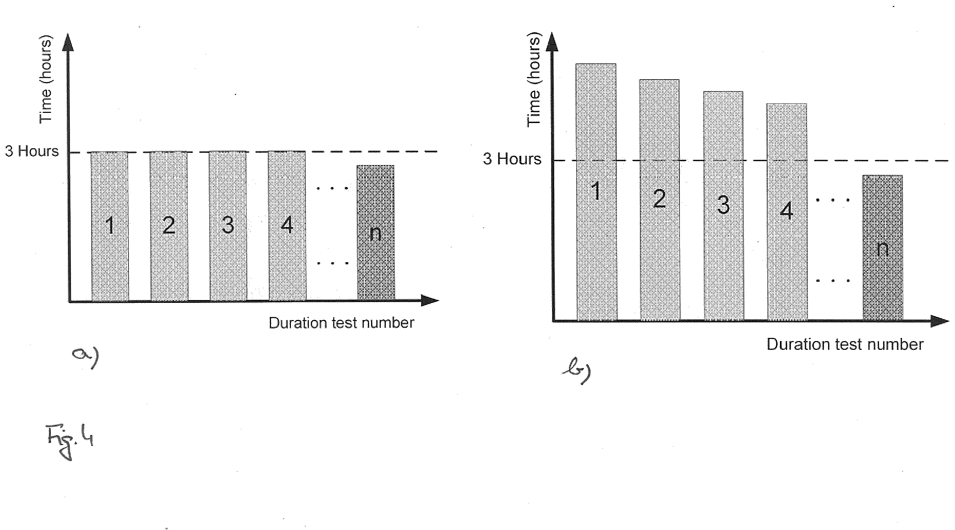

As it will be described below in greater detail, it is particularly preferred that at least part of the measurement values determined by the operating device 5 result from a duration test, in which the battery 3 is discharged until a certain threshold level is reached. This threshold level preferably is the so-called cut-off level and is close to an almost fully discharged battery 3. The duration test for discharging the battery to the cut off level differs from a compulsory rated duration test for emergency luminaires 2, which will be described later with reference to fig. 4.

According to the invention, the duration test is initiated by the control device 11, which sends a (DALI) command to the operating device 5 defining the duration test to be performed. It is to be noted, that it is possible that the rated duration test and the duration test may both be triggered by a command from the control device 11 to the operating device 5. Basically, a same or similar command can be used indicating in a command parameter which of the duration tests shall be performed. The commands that maybe used for instructions from the control device 11 to the operating device 5 might for example use the DALI bus system.

Once the measurement is performed by physically sensing certain characteristics of the component of interest, the respective measurement values are stored in the internal memory 9 of the operating device 5. As it was explained above already, the memory 9 of the blackbox included in the operating device 5 has only a small capacity and, thus, in case that new measurement values (or information on events that occurred in the operating device or the entire emergency luminaire ₂) are determined, the oldest measurement values (or information on events, respectively) are overwritten. Thus, the data stored in the internal memory 9 is available only for a certain time interval until the data is overwritten. According to the invention, data which is stored in the internal memory 9 is transferred, preferably at regular time intervals, and stored in the external memory 12. The data that is to be transferred from the internal memory 9 to the external memory 12 can be polled using another DALI command sent by the control device 11.

The capacity of the external memory 12, compared to the internal memory 9, is significantly larger and, thus, allows to accumulate data transferred from the internal memory 9 to the external memory 12. Over time, the databases that is generated in the external memory 12 enhances so that an analysis performed on this database has a higher accuracy.

Measurement values and information on events which is derived from physically sensing characteristics of components and calculations based on the physically sensed characteristics that are typically stored in the internal memory 9 are: total unit operating time as time base for the system, maximum gear temperature, count of battery high battery temperature faults, count of low battery temperature faults, count of duration test 1 emergency events, count of the battery reaching low voltage battery cut-off, battery average temperature, battery minimum temperature, and battery maximum temperature. As it will be understood from the parameter "battery maximum temperature", cyclically overwriting the stored value causes loss of information. This is avoided by the present invention, which transfers the data stored in the internal memory 9 to the external memory 12.

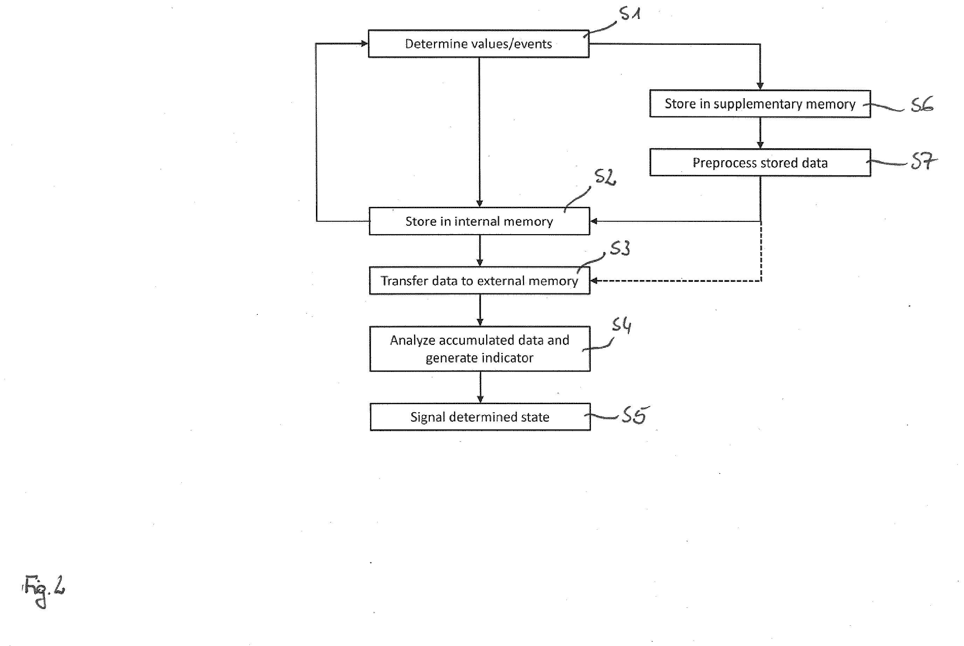

Figure 2 explains in a simplified flowchart the inventive method. The measurement values or events are determined in step S₁ and stored in the internal memory 9 in step S2. As indicated by the arrow going back from step S2 to step Si, the determination and storing the respective results in the internal memory 9 is performed repetitively. It is obvious that overwriting values only occurs in case that the newer values need to be store, for example, when a new peak value(minimum value) is higher (lower) than the already stored one. Other values such as run time are stored continuously.

The data stored in the internal memory 9, or at least parts thereof, is transferred to the external memory 12 either using a preprogrammed routine in the operating device 5 or upon the respective request received from the control device 11, which is preferred. The time interval between successive data transfer from the internal memory 9 to the external memory 12 may be reduced while performing measurements that require high time resolution, data in the internal memory 9 is overwritten.

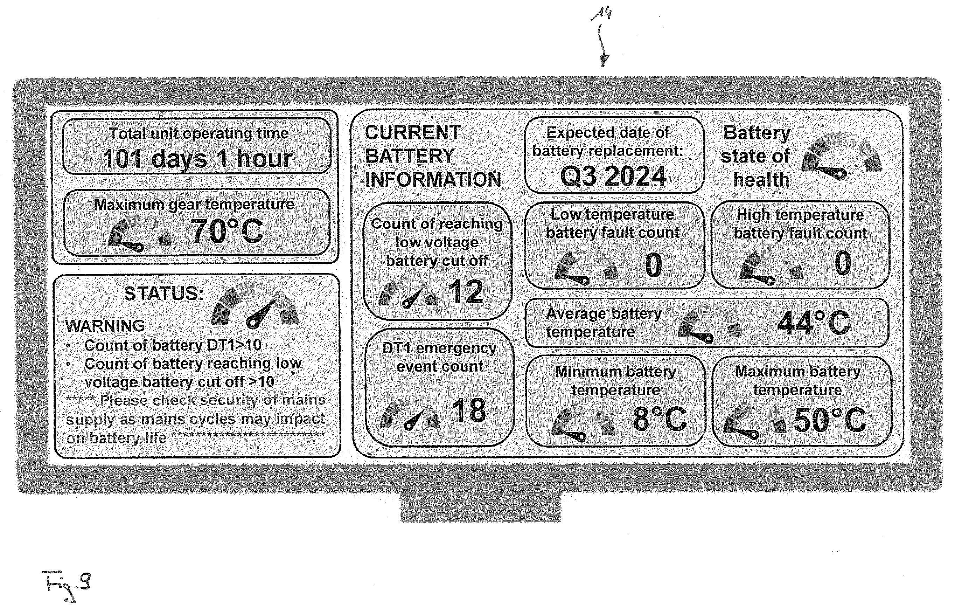

In order to facilitate an adaptive maintenance of the emergency luminaire 2, the data which is then accumulated in the external memory 12 is analysed by the processing means 13. In the processing means 13 an indicator is generated (step S4) which defines and identifies a state of the respective component. Examples for such states will be explained hereinafter. Finally, the determined state of the respective component is signalled in step S5. An example for displaying information based on the determined state and the respectively generated indicator will be explained later with respect to figure 9.

In order to improve the database on which the analysis is performed, it is desirable to provide even more measurement values or additional information on events. Since the internal memory 9 is of a limited capacity, measurement values obtained from additional measurements and/or information on events determined from additional measurements are stored in the supplementary memory 10 in step S6. According to preferred embodiment, this supplementary memory 10 allows to store a great amount of data, for example, measurement values determined with short time intervals. In the flowchart illustrating the method according to the invention, it is assumed that the data stored in the supplementary memory 10 is preprocessed before it is transferred to the external memory 12. However, such preprocessing of this data stored in the supplementary memory 10 does not need to be performed. It is also possible, that the unprocessed data is directly transferred to the external memory 12.

The preprocessing of the data may include for example calculating an average, determining the peak value or determining a minimum value. Such preprocessing significantly reduces the amount of data, so that the result of the preprocessing may then be stored in the internal memory 9. Once stored in the internal memory 9, the data may then be transferred as explained above in response to a respective command received from the control device 11 to the external memory 12. Alternatively, the preprocessed data is stored in the supplementary memory 10 (or even the unprocessed data) and it could directly be transferred to the external memory as indicated by the dashed arrow between steps S7 and S3.

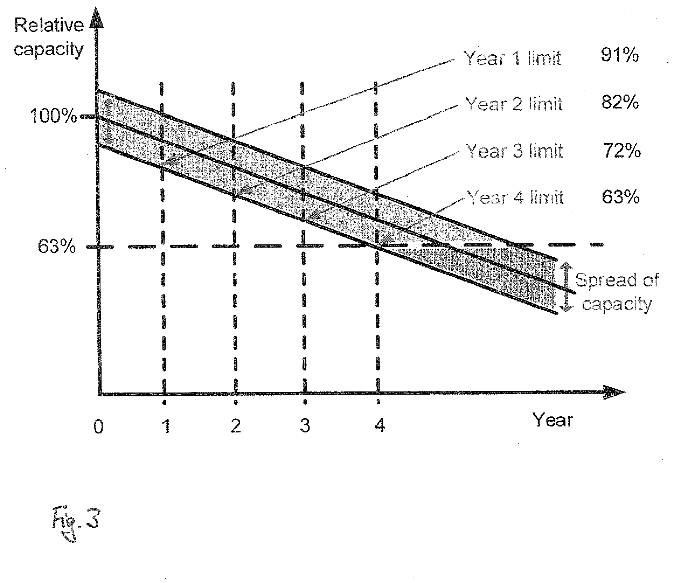

The analysis of the data and the generation of the indicator according to step S4 and signalling the determined state according to step S5 takes into consideration at least some of the data stored in the external memory 12. Thus, in case that a supplementary memory 10 is used in order to store data, and the data is then transferred to the external memory 12, the respective measurement values or information on events accumulated in the external memory 12 is automatically taken into consideration by the analysis performed based on the data accumulated in the external memory 12. Figure 3 shows the degradation of the battery capacity and, thus, the decay of the battery 3 over time. This can be derived from life testing and modelling of the battery used in the system which is a typical step before a battery is approved for use in an emergency luminaire. Therefore, limit relative capacity values at each duration event where a battery should be in order to reach its life are determined in advance. The models may factor in the operating temperature and therefore offer adaptive limits according the battery use case or the limits may be set to cover the worst case normal operating temperature.

By determining the relative capacity of the battery 3, it is therefore possible to detect a battery 3 that must be replaced even in case that the required life expectancy of the battery is not reached. The capacity is determined from the duration test in which the battery 3 is discharged until a certain threshold is reached. The ratio between the actual capacity of the battery and the initial capacity of the battery is calculated as relative capacity as indicated in fig. 3. The initial capacity of the battery 3 can be determined when the emergency luminaire 2 is commissioned, or when a new battery is inserted in the emergency luminaire 2. Then, triggered by the control device 11 or automatically initiated by the luminaire 2 itself, the duration test is performed in order to determine the initial capacity of the battery. This value is then stored in order to determine the relative capacity of the battery 3 each time a new duration test is performed and the actual capacity of the battery 3 is determined.

The state of health of the battery is then determined based on the relative capacity of the battery 3. In the simplest way, only two states of the battery 3 exist: in good order or faulty. These two states can be distinguished by comparing the relative capacity with a threshold. The threshold, as indicated in the drawing, changes with time. The change with time takes into account that naturally the relative capacity of a battery 3 decreases over time, which does not mean that the respective battery 3 is in a bad condition.

In an ideal scenario, the decrease of the capacity of a battery would follow the line starting at 100% in the drawing. However, due to changing circumstances and unpredictable environmental influence, a range for the relative capacity may be considered to be allowable. This range is indicated in the drawing by "spread of capacity". Only in case that the determined relative capacity at a certain point in time falls below the lower limit of the range for the relative capacity, the battery 3 is considered to be faulty. Any value above the lower limit of the range is considered to be the state "in good condition". Additinally, the battery capacity falling below the lower limit of the range may also indicate that something is wring in the system. Thus, when such low relative capacity is recognize additional investigation on reasons for such situations (e.g. high temperature, too many cycles, etc.) can be made.

Fig. 4 now illustrates the difference between the rated duration test and the duration test, which is performed according to the present invention. On the left side, the rated duration test is illustrated. The test shown in fig. 4 is always limited to 3 hours, which corresponds to the rated duration for which in case of emergency the emergency luminaire 2 must be capable of emitting light. Contrary, the duration test for determining the actual capacity and, in the end, the relative capacity (or to be more precise: decay of the relative capacity over time), discharges the battery 3 until a certain state of charge threshold is reached. This state of charge threshold is a threshold, which is close to a fully discharged state of the rechargeable battery 3 and the threshold does not change over time. As can be seen from the drawing, the rated duration test does not show any change of the battery until the rated duration of 3 hours cannot be reached any longer. However, using the duration test, which discharges the battery to a fixed threshold for the state of charge, allows to identify degradation of the battery from the start.

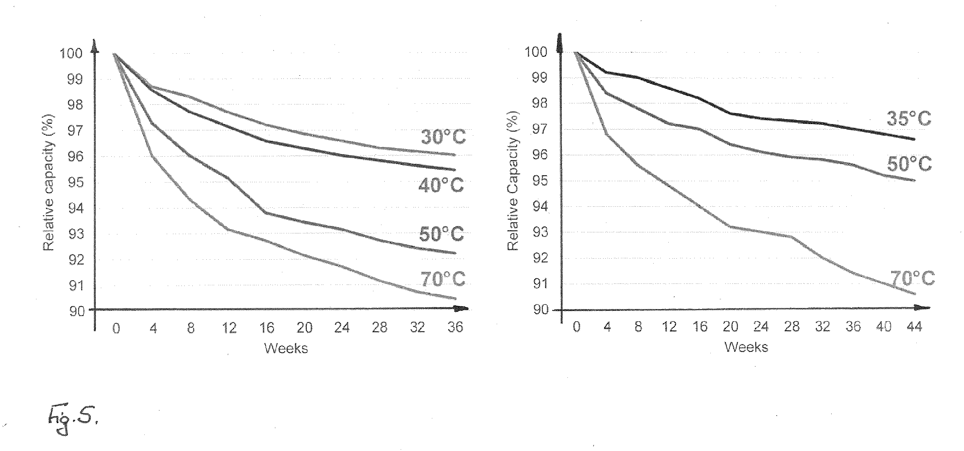

Figure 5 is an illustration showing decay of the relative capacity of batteries experiencing different temperatures. It can be seen that the higher the temperature, the stronger a decrease of the relative capacity over time is. Further, two different battery types are shown in the left part of the figure and in the right part of the figure. As it can be seen, for different battery types different ageing may be expected. This knowledge can be used in order to predict the remaining life expectancy of a battery 3. The prediction is based on the model, which can be established for the battery 3, given different models for different battery types. The model is a mathematical description for the decrease of the capacity over time using the measurement values and information on events experienced in the past as input values. This model is used for a prediction of the remaining lifetime and can thus be used in order to suggest a date for replacement of the battery. For example, the predicted date when the battery relative capacity falls below 90% is used for suggesting the replacement of the battery. It is to be noted that a single model using different parametrisation might be understood as different models. Thus, an adaptation of the model is possible by using different parameterisation of the model based on knowledge of the battery type.

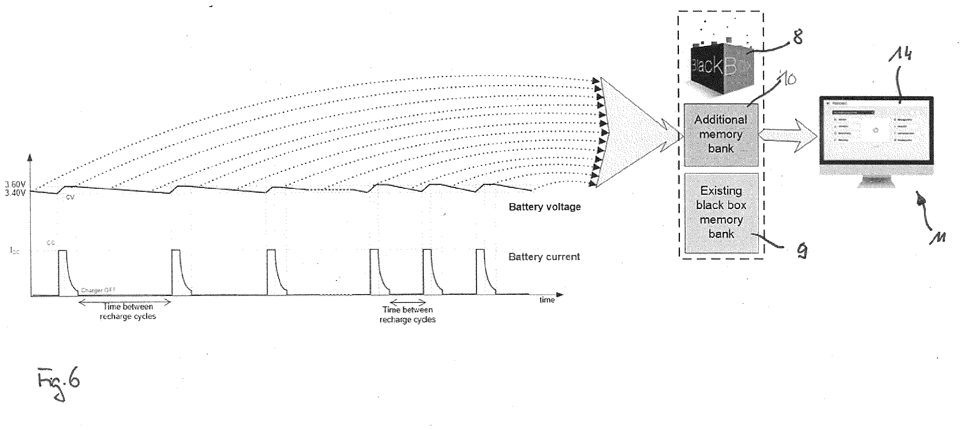

It is to be noted that the model may take into consideration a plurality of different parameters, not only the battery type or temperature for which the influence was illustrated in fig. 5. There are some parameters that significantly depend on the ageing of the battery 3. One of these parameters is the amount of micro charge cycles, which can therefore be used to determine the state of health of the battery. As it is illustrated in figure 6, these micro charge cycles can be identified by regularly measuring the battery voltage. Since such measurements performed at short time intervals produce a significant amount of data, the measured battery voltages are stored in the supplementary memory 10 of the operating device 5. This information is then transferred to the external memory 12 so that it can be processed for the analysis of the state of the battery 3. For example, the course of the battery voltage over time can be used as an input for the model predicting the remaining lifetime of the battery three.

The additional measurements further support the accuracy of he model and predicated battery replacement date. The model describes the aging o a battery but is based upon a previous life test result. By also monitoring how the capacity is actually degrading as well as monitoring parameters that influence that aging suh as battery voltage, temperature, discharge cycles etc., the accuracy of the prediction can be improved.

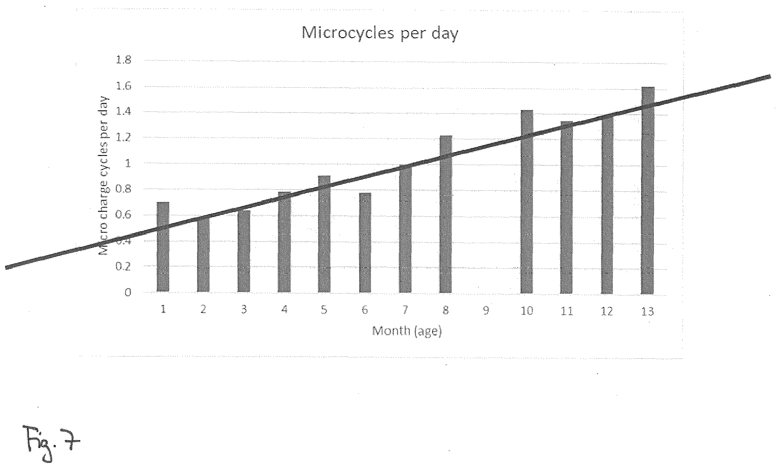

Alternatively, preprocessing of the measured voltages of the battery 3 can be performed such that only the number of micro charge cycles per time interval is stored and transferred to the external storage. In figure 7 it is shown that the number of micro cycles increases with the age of the battery 3. Thus, in case that the number of micro cycles exceeds the amount that could be expected for the actual age of the battery 3, it can be assumed that the remaining lifetime of the battery 3 is reduced. The influence on the expected remaining lifetime of the battery 3 is defined in the model, which, as an input, uses information on the determined micro charge cycles.

The situation is similar for the temperature of the battery 3. Thus, a temperature chart of the battery 3 allows to more accurately determine the remaining lifetime. Thus, the battery temperature is regularly measured and stored in the supplementary memory 10. As it is indicated in the drawing, the respective values are transferred from the supplementary memory 10 to the external memory 12 once a day or twice a day. Of course, other time intervals for transferring the data can be thought of, taking into consideration the available memory in the operating device 5.

Figure 9 shows an example for a dashboard, which, in the right upper corner, directly displays the state of the battery 3 of the emergency luminaire 2. The state of health is only saying if the battery is aging according expectation and does not predict the replacement date. It uses the full discharge test (duration test to fixe state of charge threshold) to determine if the battery is aging at a rate equal to or below which is expected for example at maximum temperature.

A further step is to use a model to predicate the actual date of replacement based upon a wide range of measurement parameters.

In the illustrated embodiment, the battery 3 is in good condition so that the pointer points to the left end of the scale. Besides this indication of the state of health of the battery 3, the expected date of battery replacement is displayed left hand besides the battery state. The predicted date for battery replacement is calculated using the model based on the measurement values.

In addition to the indication of the state of health of the battery 3 and the predicted or suggested replacement date of the battery, further information is presented to the operator: This information might be a direct display of measured values or a count events, for example. Additional information is intended to allow the operator a deeper insight into the system so that reasons for certain behaviours or rapid ageing of the battery 3 might be identified. It is to be noted that all information which is displayed on the display 14 as illustrated in figure 9 is only shown as an example and other configurations of the dashboard might be thought of.

## Claims

1. Method for facilitating maintenance of an emergency lighting system (1) in which an operating device (5) is configured to at least temporarily operate a light source (4) from electrical energy stored in a rechargeable battery (3), the method comprising the following method steps:
- repetitively determining (Si) system measurement values and/or events during operation of the operating device (5),
- storing (S2) the determined measurement values and/or information on the determined events in an internal memory (9) of the operating device (5), and cyclically overwriting the oldest corresponding measurement values or information on determined events, respectively,
- transfer (S3) at least part of the stored measurement values and/or information to an external memory (12) at a plurality of different times thereby accumulating measurement values and/or information on events in the external memory (12),
- analyzing (S4) at least part of the accumulated measurement values and/or information on events to determine a state of at least one component of the emergency lighting system (1), and generating an indicator for the determined state,
- signalling (S5) the determined state of the at least one component based on the indicator.

2. Method according to claim 1,
**characterized in that**
in the analysis (S4), a comparison of at least one of the accumulated measurement values or the information on events with respective thresholds is performed and the indicator represents the analysis result.

3. Method according to claim 1 or 2,
**characterized in that**
the at least one component comprises the rechargeable battery (3), and a battery capacity is determined (S1) as measurement value in a duration test discharging the rechargeable battery (3) to a state of charge threshold.

4. Method according to claim 3,
**characterised in that**
the operating device (5) is controlled to discharge the rechargeable battery (3) in the duration test until a fixed state of charge threshold is reached in order to determine the battery capacity.

5. Method according to claim 3 or 4,
**characterized in that**
a relative capacity is calculated from the determined battery capacity and an initial battery capacity stored in the external storage, and the relative capacity is compared with a capacity threshold which is a function of battery age.

6. Method according to any one of the preceding claims
**characterized in that**
the determined state of a component comprises information on how much of the battery's life expectancy remains.

7. Method according to anyone of the preceding claims,
**characterized in that**
the determined state is calculated using a model into which at least a plurality of measurement values and/or information on events stored in the external memory (12) is input.

8. Method according to any of the preceding claims,
**characterized in that**
the determined state(s) of the at least on component are signalled (S5) in a dashboard for visualization of the determined state(s) of the at least one component.

9. Method according to anyone of the preceding claims,
**characterized in that**
an internal analysis of the measurement values and/or information on the determined events is performed by a monitoring unit of the operating device.

10. Method according to anyone of the preceding claims,
**characterized in that**
additional measurement values and/or information on events are stored in a supplementary memory.

11. Method according to claim 10,
**characterized in that**
an amount of data held in the supplementary memory is reduced before it is transferred to the external memory by pre-processing the measurement values and/or information on events.

12. Method according to claim 11
**characterized in that**
the preprocessing comprises at least one of: calculating an average value, determining a peak value and determining a minimum value.

13. Method according to any one of claims 1 to 12
**characterized in that**
the time interval between successive determinations of measurement values stored in the supplementary memory (10) is smaller than the time interval between successive determinations of measurements stored in the internal storage (9).

14. Emergency lighting system comprising a rechargeable battery (3), an operating device (5) configured to at least temporarily operate a light source (4) from energy stored in the rechargeable battery (3), the operating device (5) comprising an internal memory (9) and processing means (8), wherein the operating device (5) is configured to determine and store measurement values and/or information on events in the internal memory (9) and to transfer at least part of the stored measurement values and/or information on events to an external memory (12), in which the transferred measurement values and/or information on events are accumulated, and wherein the processor (13) is configured to analyse at least part of the accumulated measurement values and/or information on events to determine a state of at least one component of the emergency lighting system (1) and to generate an indicator for the determined state, the emergency lighting system further configured to signal the determined state.

15. Emergency lighting system according to claim 14,
**characterized in that**
the at least one component comprises the rechargeable battery (3) and the operating device is configured to discharge the rechargeable battery (3) in a duration test until a state of charge threshold is reached.
